# EUROPEAN PATENT APPLICATION

(11) **EP 4 611 500 A1**
(43) Date of publication of application: **03.09.2025**
(21) Application number: 24160302.6
(22) Date of filing: 28.02.2024
(51) Int. Cl.: H10B 53/30

(54) **FERROELECTRIC DEVICE AND METHOD**

(71) Applicant: Huawei Technologies Co., Ltd., Shenzhen, Guangdong 518129 (CN)
(72) Inventor: Li, Wei, 80992 Munich (DE); Jin, Ming, 80992 Munich (DE); Sang, Xia, 80992 Munich (DE); Leonelli, Daniele, 80992 Munich (DE)
(74) Representative: Roth, Sebastian

(57) **Abstract**

A ferroelectric device (100) comprising a substrate (110) and at least one region (120) arranged above a top side of the substrate is provided. The at least one region comprises a first electrode (122) arranged above the substrate and comprising a first metal, a ferroelectric layer (124) arranged above the first electrode, a second electrode (128) arranged above the ferroelectric layer and comprising a second metal, and a template layer (126) having a preferred lattice orientation. The template layer is arranged between the substrate and the first electrode and is directly in contact with it, or the template layer is arranged above the second electrode and is directly in contact with it. The first electrode has the preferred lattice orientation of the template layer if it is directly in contact with the template layer. Alternatively, the second electrode has the preferred lattice orientation of the template layer if it is directly in contact with the template layer.

## Description

### TECHNICAL FIELD

The present disclosure relates to a ferroelectric device, for example, a ferroelectric capacitor with a template layer. The disclosure also relates to a method for fabricating the ferroelectric device.

### BACKGROUND

Hafnium-based ferroelectric memories have the advantages of being compatible with current complementary metal-oxide-semiconductor (CMOS) technologies, good shrinkage, high density, non-volatility, and low power consumption, making it the most promising emerging storage medium.

Hafnium-based ferroelectric devices mainly use hafnium zirconium oxide (HfZrOx or HZO) as the ferroelectric material. A preparation process for this kind of devices is based on atomic layer deposition (ALD) of an HfZrOx layer followed by high-temperature annealing to crystallize it. After crystallization, HfZrOx is a polycrystalline component, and the orientation of each crystal grain is difficult to control, so that the crystal grains tend to be randomly oriented. This causes a flipping coercive field of each ferroelectric domain to be different, which is manifested in the fact that the polarization intensity of a HfZrOx-based ferroelectric capacitor (FeCAP) changes with an applied electric field. Consequently, a polarization versus voltage hysteresis loop (or P-V loop) of the FeCAP is not square. This phenomenon leads to a reduction in the interference immunity of the memory cells.

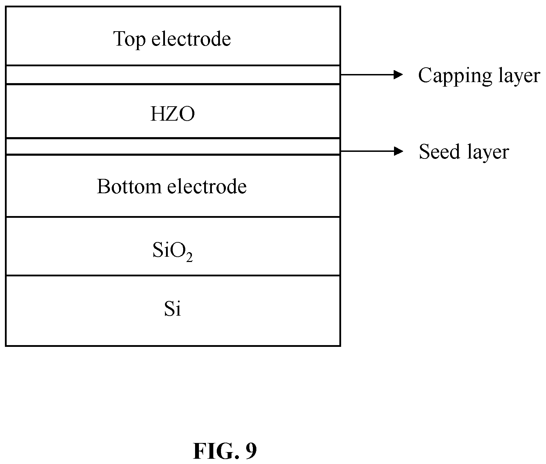

FIG. 9 schematically depicts a conventional structure of a hafnium-based FeCAP. A bottom electrode is grown on a Si/SiO₂ substrate. Then, optionally, a seed layer is grown on the substrate. Subsequently, a ferroelectric material layer made of HZO is deposited on the seed layer. Further, optionally, a capping layer is deposited on the ferroelectric material layer, and a top electrode is deposited on top of it.

However, in this conventional structure, the bottom electrode is deposited directly on the amorphous substrate. Further, the bottom electrode is usually polycrystalline, without a lattice preferred orientation. Typically, the HZO is also polycrystalline without lattice preferred orientation and, consequently, the P-V loop of the conventional HZO-FeCAP is not square-like.

### SUMMARY

In view of the above, this disclosure aims to improve conventional FeCAPs. An objective is to provide a ferroelectric device that enables the control of the grain orientation of the used ferroelectric material, thereby increasing the polarization intensity of the FeCAP and optimizing the shape of the P-V loop curve.

These and other objectives are achieved by this disclosure as described in the independent claims. Advantageous implementations are described in the dependent claims.

A first aspect of this disclosure provides a ferroelectric device comprising a substrate and at least one region arranged above a top side of the substrate. The at least one region comprises a first electrode arranged above the substrate and comprising a first metal, a ferroelectric layer arranged above the first electrode, a second electrode arranged above the ferroelectric layer and comprising a second metal, and a template layer having a preferred lattice orientation. The template layer is arranged between the substrate and the first electrode and is directly in contact with the first electrode, or the template layer is arranged above the second electrode and is directly in contact with the second electrode. The first electrode has the preferred lattice orientation of the template layer if it is directly in contact with the template layer; alternatively, the second electrode has the preferred lattice orientation of the template layer if it is directly in contact with the template layer.

By using a template layer having a preferred lattice orientation, said preferred lattice orientation can be induced in the first electrode when the template layer is in direct contact with the first electrode. Then, the first electrode can in turn induce the preferred lattice orientation in the ferroelectric layer, thereby increasing the polarization intensity of the ferroelectric device and optimizing the shape of the P-V loop curve exhibited by the ferroelectric device, when it is use as a FeCAP.

Alternatively, when the template layer is in direct contact with the second electrode, the template layers an induce its preferred lattice orientation can be induced in the second electrode, which in turn can induces the preferred lattice orientation in the ferroelectric layer, thereby increasing the polarization intensity of the ferroelectric device and optimizing the shape of the P-V loop curve exhibited by the ferroelectric device.

In an implementation form of the first aspect, the template layer comprises a first polycrystalline material. The first polycrystalline material comprises a plurality of crystal grains of the first material, wherein each of the plurality of the crystal grains of the first material has a same lattice orientation.

Polycrystalline materials consist of many crystals or "grains". The grains are separated by grain boundaries and can have random crystal orientations with no preferred direction. Alternatively, for example due to growth and processing conditions, the crystal grains can be aligned in a same direction. When a majority of the many crystal grains are oriented in this way, the polycrystalline material is said to have a preferred orientation.

Further, that each crystal grain is aligned in a certain direction means that a crystal axis of said crystal grain faces said direction.

In this disclosure, that each of the plurality of the crystal grains of the first material has a same lattice orientation refers to a composition or a majority of the plurality of the crystal grains of said first material having the same or substantially the same lattice orientation, i.e., being oriented in the same direction. For example and not as a limitation, 95% or 75% or 55% of the crystal grains of the first material may be oriented in the same direction.

Further, in this disclosure, the same direction means that the angles among these crystal grains orientation may be within 30 degrees.

In an implementation form of the first aspect, the polycrystalline material comprises AlN and/or Al₁₋ₓScₓN (0<x<0.9).

AlN and AlScₓN are each a polycrystalline material, but its grain orientations are consistent. That is, a certain crystal axis of each crystal grain faces the same direction. Polycrystalline AlN or polycrystalline AlScₓN with consistent orientation, or preferred orientation, can influence the lattice orientation of the first electrode or of the second electrode, thereby controlling the grain orientation of the ferroelectric layer, which results in increasing the polarization intensity of the ferroelectric device and optimizing the shape of the P-V loop curve of the ferroelectric device.

In an implementation form of the first aspect, claim 3, a thickness of the template layer is between 5 nanometer, nm, and 1 micrometer, µm.

For example, the thickness of the template layer may be between 5 nm and 50 nm, or between 5 nm and 80 nm or between 10 nm and 80 nm or between 15 nm and 90 nm or between 50 nm and 90 nm or between 50 nm and 1 µm. Preferably, the thickness of the template layer may be between 15 nm and 100 nm.

In an implementation form of the first aspect, the ferroelectric layer comprises a ferroelectric polycrystalline material having the lattice orientation of the template layer.

By using the template layer having the preferred lattice orientation being in direct contact with either the first electrode or the second electrode, said preferred lattice orientation is induced either in the first electrode or the second electrode. Due to the proximity of the ferroelectric layer to the first electrode or to the second electrode, a plurality of crystal grains of the ferroelectric polycrystalline material are oriented in the same direction as the crystal grains of the template layer.

In an implementation form of the first aspect, the ferroelectric polycrystalline material comprises HZO.

This provides the advantage that the ferroelectric device is compatible with current CMOS technologies.

In an implementation form of the first aspect, a thickness of the ferroelectric layer is between 3 nm and 20 nm.

For example, the thickness of the ferroelectric layer may be between 3 nm and 10 nm, or between 5 nm and 15 nm or between 10 nm and 20 nm. Preferably, the thickness of the template layer may be between 5 nm and 10 nm.

In an implementation form of the first aspect, the first electrode having the preferred lattice orientation of the template layer comprises a plurality of crystal grains of the first metal, wherein each of the plurality of the crystal grains of the first metal has the same lattice orientation as the first polycrystalline material.

By placing the template layer having the preferred lattice orientation in direct contact with the first electrode, said preferred lattice orientation is induced in the first electrode, which in turn enables to control the lattice orientation of the ferroelectric layer by inducing the preferred lattice orientation in it.

In an implementation form of the first aspect, wherein the first metal comprises Mo or/and W and/or TiN.

In an implementation form of the first aspect, a thickness of the first electrode is between 10 nm to 50 nm.

In an implementation form of the first aspect, the second electrode having the preferred lattice orientation of the template layer comprises a plurality of crystal grains of the second metal, wherein each of the plurality of the crystal grains of the second metal has the same lattice orientation as the first polycrystalline material.

When the template layer having the preferred lattice orientation being in direct contact with the second electrode, said preferred lattice orientation is induced in the second electrode, which in turn enables to control the lattice orientation of the ferroelectric layer.

In an implementation form of the first aspect, the second metal comprises Mo and/or W and/or TiN.

In an implementation form of the first aspect, a thickness of the second electrode is between 5 nm to 50 nm.

In an implementation form of the first aspect, the at least one region further comprises a seed layer arranged between the first electrode and the ferroelectric layer, wherein the seed layer comprises an oxide material, and wherein a thickness of the seed layer is between 0.5 nm and 3 nm.

The seed layer adds stress to the HZO ferroelectric layer, and/or supplies oxygen to the HZO ferroelectric layer to stabilize a ferroelectric phase of HZO layer.

In an implementation form of the first aspect, the at least one region further comprises a capping layer arranged between the ferroelectric layer and the second electrode, wherein the capping layer comprises a metal oxide material, and wherein a thickness of the capping layer is between 0.5 nm and 3 nm.

The capping layer may supply oxygen to the HZO ferroelectric layer to stabilize the ferroelectric phase of HZO layer.

In an implementation form of the first aspect, the ferroelectric device comprises more as one region that are arranged next to each other.

Each of the regions are identical to the at least one region. Thereby, a memory or an array of ferroelectric capacitors can be implemented, which enjoys the advantages of the ferroelectric device described above.

A second aspect of this disclosure provides a method for fabricating a ferroelectric device. The method comprises: providing a substrate, and forming at least one region above a top side of the substrate, comprising: forming a first electrode above the substrate and comprising a first metal; forming a ferroelectric layer above the first electrode; forming a second electrode above the ferroelectric layer and comprising a second metal; and forming a template layer between the substrate and the first electrode and being directly in contact with the first electrode; or forming the template layer above the second electrode and being directly in contact with the second electrode. The template layer has a preferred lattice orientation, and the first electrode has the preferred lattice orientation of the template layer if it is directly in contact with the template layer; alternatively, the second electrode has the preferred lattice orientation of the template layer if it is directly in contact with the template layer.

The method of the second aspect may have implementation forms, which correspond to the ferroelectric device of the first aspect, that is, the method may produce each implementation form of the ferroelectric device. The method of the second aspect and its implementation forms may achieve the same advantages as described above for the ferroelectric device of the first aspect and its corresponding implementation forms.

### BRIEF DESCRIPTION OF DRAWINGS

The above described aspects and implementation forms will be explained in the following description of specific embodiments in relation to the enclosed drawings, in which;
- FIG. 1: schematically depicts a cross-section of a ferroelectric device according to this disclosure.
- FIG. 2: schematically depicts a preferred lattice orientation of a template layer according to this disclosure.
- FIG. 3: schematically depicts a cross-section of another ferroelectric device according to this disclosure.
- FIG. 4: schematically depicts a cross-section of another ferroelectric device according to this disclosure.
- FIG. 5: schematically depicts a cross-section of another ferroelectric device according to this disclosure.
- FIG. 6: schematically depicts a cross-section of another ferroelectric device according to this disclosure, comprising two regions.
- FIG. 7: shows a method according to this disclosure for fabricating a ferroelectric device.
- FIG. 8a)-d): schematically depict an example for fabricating the ferroelectric device of FIG. 6, according to this disclosure.
- FIG. 9: schematically depicts a cross-section of a conventional ferroelectric device.

In the figures, same elements are labeled with the same reference signs, and may be implemented likewise. The size of elements in the figures is not to scale and may be different compared to a real-life implementation in order to highlight details of the embodiments.

### DETAILED DESCRIPTION OF EMBODIMENTS

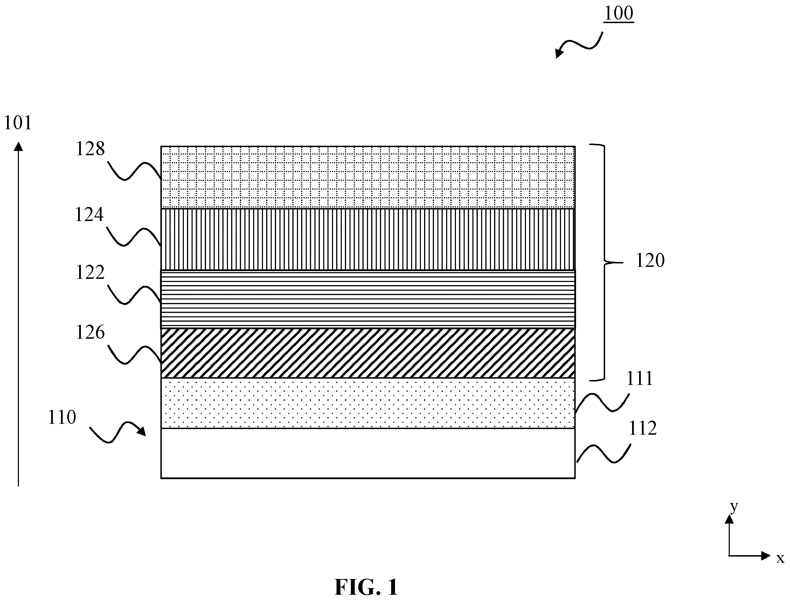

FIG. 1 shows a cross-section of an exemplary embodiment of a ferroelectric device 100 according to this disclosure. The ferroelectric device 100 may be a FeCAP. Additionally or alternatively, the ferroelectric device 100 may be used for or in a memory, in particular a ferroelectric memory.

The ferroelectric device 100 comprises a substrate 110. The substrate 110 may be, for instance, a silicon or a silicon-based layer, substrate, or wafer. For example, as shown in FIG. 1, the substrate 110 may comprise a SiO₂ insulation layer 112 grown on a Si layer or substrate 111.

Further, the ferroelectric device 100 comprises at least one region 120 arranged above the substrate 110. The at least one region 120 comprises a first electrode 122 arranged above the substrate 110 and comprising a first metal. Further, the at least one region 120 comprises a ferroelectric layer 124 arranged above the first electrode 122. The ferroelectric layer 124 comprises a ferroelectric material, for example, HZO. The at least one region 120 further comprises a second electrode 128 arranged above the ferroelectric layer 124 and comprising a second metal.

In the exemplary embodiment according to FIG. 1, the ferroelectric layer 124 is arranged above the first electrode 122 and is directly in contact with the first electrode 222, and the second electrode 128 is arranged above the ferroelectric layer 124 and is directly in contact with the ferroelectric layer 124.

Further, the at least one region 120 comprises a template layer 126 having a preferred lattice orientation. In this exemplary embodiment, the template layer 126 is arranged between the substrate 110 and the first electrode 122, as is directly in contact with the first electrode 122.

Thus, in this exemplary embodiment, the first electrode 122 has the preferred lattice orientation of the template layer 126.

Further, the ferroelectric device 100 comprising the substrate 110 and the at least one region 120 may be a stack.

Depending on the conditions of forming the ferroelectric device 100 (i.e. the growth conditions), a layer/region provided on top of another layer/region may cover any exposed surface of the region/layer below only partly or completely. Also, a thickness of the layer/region on the surface of the region/layer below it can be controlled, particularly relative to the thickness of the layer/region on the other surfaces of the region/layer beneath it.

In this disclosure, the terms "upwards", "top", "above" etc. relate to the terms "downwards", "bottom", "below" etc. according to a fabrication direction, e.g. by epitaxial growth, of the ferroelectric device 100. That is, the "lowest" point of the at least one region 120 is on the substrate 110, and the substrate 110 is "below" the at least one region 120. The at least one region 120, thus, extends "upwards" from the substrate 110 along a first direction 101, which is into the plane depicted in the cross-section shown in FIG. 1. That is, the first direction 101 may be parallel to the y axis in the reference coordinate system depicted in FIG. 1.

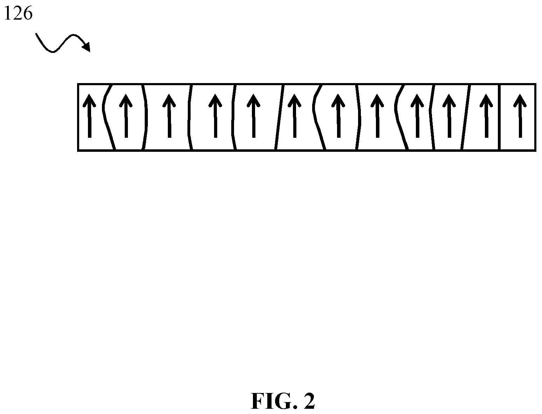

The template layer 126 having the preferred lattice orientation comprises a first polycrystalline material. The first polycrystalline material comprises a plurality of crystal grains of the first material, wherein each of the plurality of the crystal grains of the first material has a same lattice orientation. That is, a certain crystal axis of each of the plurality of crystal grains of the first material faces the same direction, as schematically depicted in FIG. 2.

The first polycrystalline material comprises AlN and/or Ali-ₓScₓN, with 0<x<0.9. AlN and Al₁₋ₓScₓN are each polycrystalline materials, but its respective grain orientations are consistent. That is, a crystal axis of each AlN grain, or of each Al₁₋ₓScₓN, faces the same direction (for example within 30 degrees). In this disclosure, a c-axis of the plurality of AlN crystal grains, alternatively of the plurality of Al₁₋ₓScₓN crystal grains, is perpendicular to the substrate110 surface plane.

A thickness of the template layer 126 is between 5 nm, and 1 µm.

For example, the thickness of the template layer may be between 5 nm and 50 nm, or between 5 nm and 80 nm or between 10 nm and 80 nm or between 15 nm and 90 nm or between 50 nm and 90 nm or between 50 nm and 1 µm. Preferably, the thickness of the template layer may be between 15 nm and 100 nm.

The first electrode 122 having the preferred lattice orientation of the template layer 126 comprises a plurality of crystal grains of the first metal, wherein each of the plurality of the crystal grains of the first metal has the same lattice orientation, or substantially the same lattice orientation, as the first polycrystalline material of the template layer 126.

The first metal of the first electrode 122 comprises Mo and/or W and/or TiN. A thickness of the first electrode 122 is between 10 nm to 50 nm.

The ferroelectric layer 124 comprises a ferroelectric polycrystalline material having the lattice orientation of the template layer 126. That is, the ferroelectric layer 124 may comprise a plurality of crystal grains of a ferroelectric material, wherein each of the plurality of the crystal grains of the ferroelectric material has the same lattice orientation, or substantially the same lattice orientation, as the first polycrystalline material of the template layer 126.

The ferroelectric polycrystalline material comprises HZO.

A thickness of the ferroelectric layer 124 is between 3 nm and 20 nm.

Further, the second metal of the second electrode 128 comprises Mo or W or TiN.

For example, the thickness of the ferroelectric layer may be between 3 nm and 10 nm, or between 5 nm and 15 nm, or between 10 nm and 20 nm. Preferably, the thickness of the template layer may be between 5 nm and 10 nm.

A thickness of the second electrode 128 is between 5 nm to 50 nm.

In this disclosure, that each of the plurality of the crystal grains of the first metal has the same lattice orientation than the first polycrystalline material of the template layer 126 means that a majority of the plurality of crystal grains of the first metal has a same lattice orientation, which in turn is the same, or substantially the same, as the lattice orientation of the (majority of) plurality of crystal grains of the first material.

Similarly, that each of the plurality of the crystal grains of the ferroelectric material of the ferroelectric layer 124 has the same lattice orientation than the first polycrystalline material of the template layer 126, means that a majority of the plurality of crystal grains of the ferroelectric material of the ferroelectric layer 124 has a same lattice orientation, which in turn is the same, or substantially the same, than the preferred lattice orientation of the (majority of) plurality of crystal grains of the first material.

In other words, in this exemplary embodiment, since the template layer 126 and the first electrode 122 are in direct contact with each other, the preferred lattice orientation of the template layer 126 can be induced or at least substantially induced in the first electrode 122. Accordingly, since the first electrode 122 and the ferroelectric layer 124 are in direct contact with each other, the preferred lattice orientation of the template layer 126 can be induced or at least substantially induced in ferroelectric layer 124, via the first electrode 122.

Moreover, since the thickness of the template layer 126 can be larger than the respective thickness of the first electrode 122 and of the ferroelectric layer 124, the control of the lattice orientation of the ferroelectric layer 124 can be facilitated.

Further, since the second electrode 128 is directly in contact with the ferroelectric layer 124 in this exemplary embodiment, said second electrode 128 may also have the same preferred lattice orientation. This is not limiting in this embodiment.

Thereby, the ferroelectric device according to the exemplary embodiment of FIG. 1, allows to control a crystal orientation of the ferroelectric layer 124. This enables to increase the polarization intensity of ferroelectric device 100 when is used as a FeCAP, and to optimize the shape of a P-V loop curve of said FeCAP.

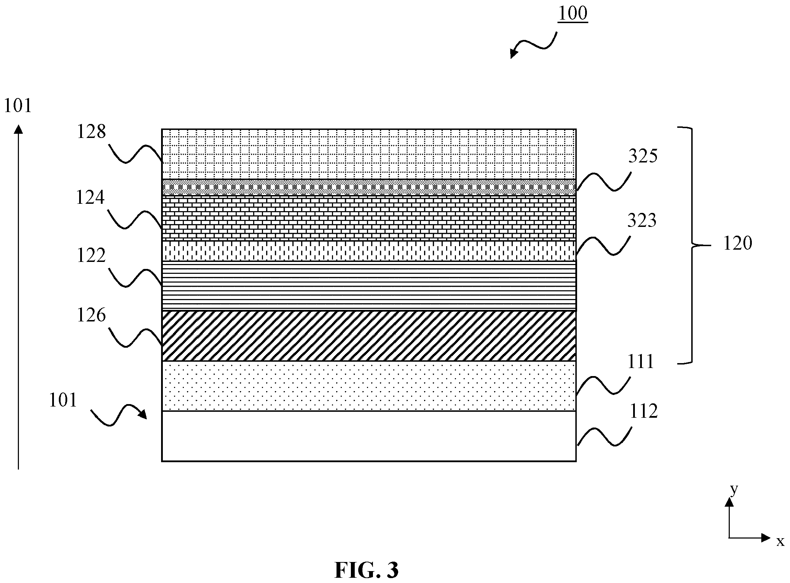

FIG. 3 shows a cross-section of an exemplary embodiment of a ferroelectric device 100 according to this disclosure, which builds on the ferroelectric device 100 shown in FIG. 1. Hereinafter, only the differences between FIG. 1 and FIG. 3 are explained.

In the embodiment according to FIG. 3, the at least one region 120 further comprises a seed layer 323 arranged between the first electrode 122 and the ferroelectric layer 124. The seed layer 323 may be directly in contact with the first electrode 122 and/or directly in contact with the ferroelectric layer 124.

The seed layer 323 comprises an oxide material.

A thickness of the seed layer 323 is between 0.5 nm and 3 nm.

Further, the at least one region 120 comprises a capping layer 325 arranged between the ferroelectric layer 124 and the second electrode 128. The capping layer 325 may be directly in contact with the ferroelectric layer 124 and/or directly in contact with the second electrode 128.

The capping layer 325 comprises a metal oxide material.

A thickness of the capping layer 325 is between 0.5 nm and 3 nm.

Since the seed layer 323 is much thinner than the first electrode 122, the ferroelectric device 100 in this exemplary embodiment allows to control the orientation of the HZO ferroelectric layer 124 by inducing the preferred lattice orientation of the transition layer 126, thereby increasing the polarization intensity of the FeCAP and optimizing the shape of its P-V loop curve.

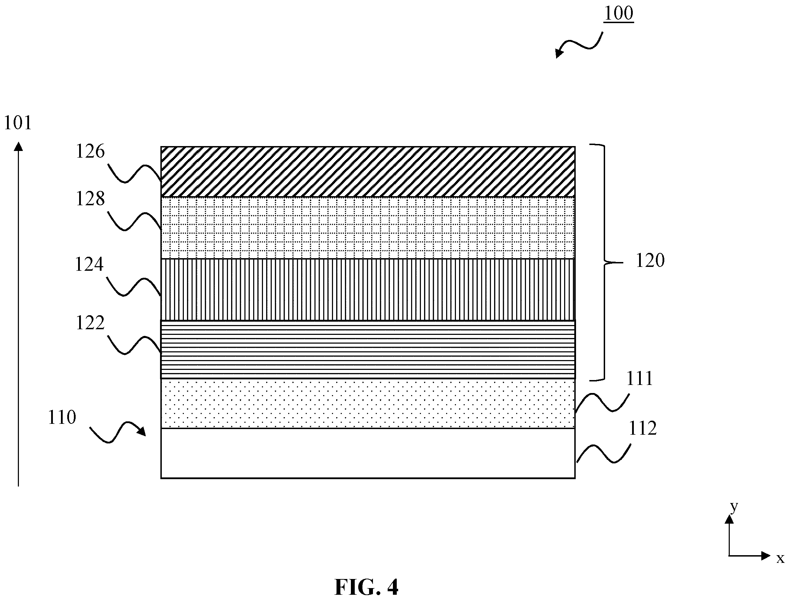

FIG. 4 shows a cross-section of an exemplary embodiment of a ferroelectric device 100 according to this disclosure, which builds on the ferroelectric device 100 shown in FIG. 1. Hereinafter, only the differences between FIG. 1 and FIG. 4 are explained.

In the embodiment according to FIG. 4, the template layer 126 is arranged above the second electrode 128 and is directly in contact with the second electrode 128.

Thus, the second electrode 128 has the preferred lattice orientation of the template layer 126.

The second electrode 128 having the preferred lattice orientation of the template layer 126 comprises a plurality of crystal grains of the second metal, wherein each of the plurality of the crystal grains of the second metal has the same lattice orientation, or substantially the same lattice orientation, than the first polycrystalline material of the template layer 126, i.e., the preferred lattice orientations of the template layer 126.

In this disclosure, that each of the plurality of the crystal grains of the second metal has the same lattice orientation than the first polycrystalline material of the template layer 126 means that a majority of the plurality of crystal grains of the second metal has a same lattice orientation, which in turn is the same, or substantially the same, than the lattice orientation of the (majority of) plurality of crystal grains of the first material, i.e., is the same as the preferred lattice orientation of the template layer 126.

In other words, in this exemplary embodiment, since the template layer 126 and the second electrode 128 are in direct contact with each other, the preferred lattice orientation of the template layer 126 can be induced or at least substantially induced in the second electrode 128. Further, the second electrode 128 and the ferroelectric layer 124 are in direct contact with each other. Accordingly, the preferred lattice orientation of the template layer 126 can be induced or at least substantially induced in the ferroelectric layer 124 via the second electrode 128.

Thereby, the polarization intensity of ferroelectric device 100 can be increased when it is used as a FeCAP, and to optimize the shape of a P-V loop curve of said FeCAP.

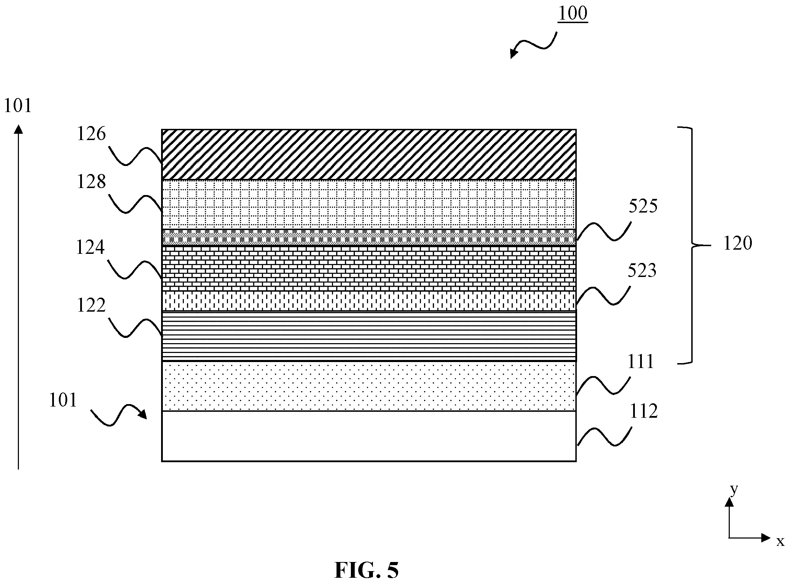

FIG. 5 shows a cross-section of an exemplary embodiment of a ferroelectric device 100 according to this disclosure, which builds on the ferroelectric device 100 shown in FIG. 4. Hereinafter, only the differences between FIG. 4 and FIG. 5 are explained.

In the embodiment according to FIG. 5, the at least one region 120 further comprises a seed layer 523 arranged between the first electrode 122 and the ferroelectric layer 124. The seed layer 523 may be directly in contact with the first electrode 122 and/or directly in contact with the ferroelectric layer 124.

The seed layer 523 comprises an oxide material. A thickness of the seed layer 523 is between 0.5 nm and 3 nm.

Further, the at least one region 120 comprises a capping layer 525 arranged between the ferroelectric layer 124 and the second electrode 128. The capping layer 525 may be directly in contact with the ferroelectric layer 124 and/or directly in contact with the second electrode 128.

The capping layer 525 comprises a metal oxide material. A thickness of the capping layer 525 is between 0.5 nm and 3 nm.

Since the capping layer 525 is much thinner than the second electrode 128, the ferroelectric device 100 in this exemplary embodiment allows to control the orientation of the HZO ferroelectric layer 124 by using the template layer 126 with the preferred lattice orientation and via the second electrode 128, thereby increasing the polarization intensity of the ferroelectric device 100 when used as a FeCAP and optimizing the shape of its P-V loop curve.

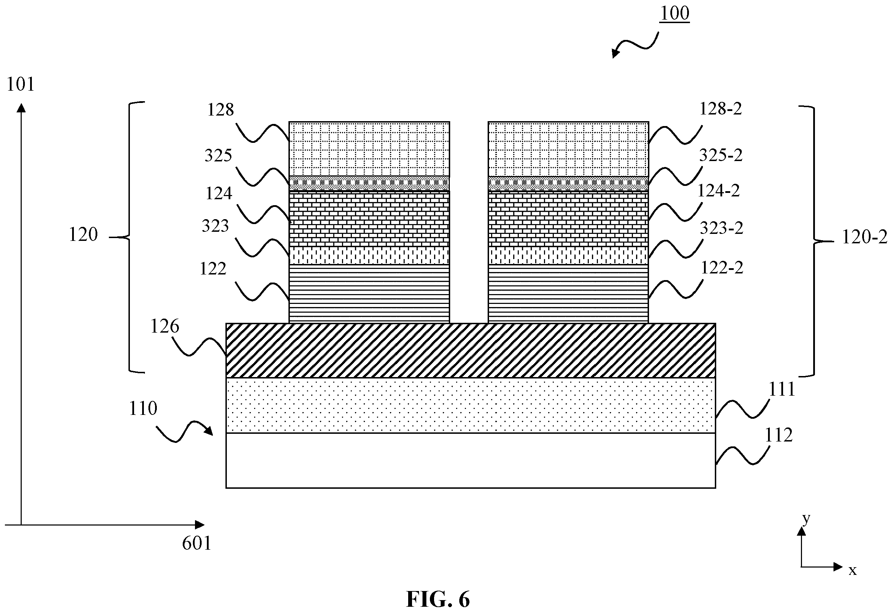

FIG. 6 shows a cross-section of an exemplary embodiment of a ferroelectric device 100 according to this disclosure, which builds on the ferroelectric device 100 shown in FIG. 3. Hereinafter, only the differences between FIG. 3 and FIG. 6 are explained.

In the embodiment according to FIG. 6, the ferroelectric device 100 comprises more than one region. For example and not as a limitation, two regions 120, 120-2 are shown in FIG. 6. Each of the regions 120, 120-2 are arranged next to each other in a second direction 601, the second direction being perpendicular to the first direction 101. For example, the second direction may be parallel to the x axis of the reference coordinate system depicted in FIG. 6.

Further, each of the regions 120-2 is identical to the region 120 disclosed above in the embodiments according to FIG. 1, FIG. 3, FIG. 4 and FIG. 5. That is, each region 120-2 may comprise a first electrode 122-2 arranged above the substrate 110 and comprising the first metal, a ferroelectric layer 124-2 arranged above the first electrode 122-2, and a second electrode 128-2 arranged above the ferroelectric layer 124-2 and comprising the second metal.

Each of the regions 120-2 may further comprise a seed layer 323-2 arranged between the first electrode 122-2 and the ferroelectric layer 124-2. The seed layer 323-2 may be directly in contact with the first electrode 122-2 and/or with the ferroelectric layer 124-2.

Further, each of the regions 120-2 may comprise a capping layer 325-2 arranged between the ferroelectric layer 124-2 and the second electrode 128-2. The capping layer 323-2 may be directly in contact with the ferroelectric layer 124-2 and/or with the second electrode 128-2.

Further, each of the regions 120-2 may comprise a template layer 126-2 having a preferred lattice orientation.

The template layer 126-2 may be arranged between the substrate 110 and the first electrode 122-2 and is directly in contact with the first electrode 122. The first electrode 122-2 may have the preferred lattice orientation of the template layer 126 if it is directly in contact with the template layer 126.

Alternatively, the template layer 126 may be arranged above the second electrode 128 and being directly in contact with the second electrode 128 (not shown). When the template layer 126 is in contact with the second electrode 128-2, the second electrode 128-2 may have the preferred lattice orientation of the template layer 126.

The first electrode 122-2, the ferroelectric layer 124-2, the second electrode 128-2 and the transition layer 124-2 may be identical to the first electrode 122, the ferroelectric layer 124, the second electrode 128 and the transition layer 124 disclosed above in the embodiments according to FIG. 1 and FIG. 3, and may be implemented likewise. Further, the seed layer 323-2 and the capping layer 325-2 may be identical to the seed layer 323 and the capping layer 325 disclosed above in the embodiments according to FIG. 3. The details are not repeated again.

The ferroelectric device 100 according to FIG. 6 may be, or may be part of, a ferroelectric memory.

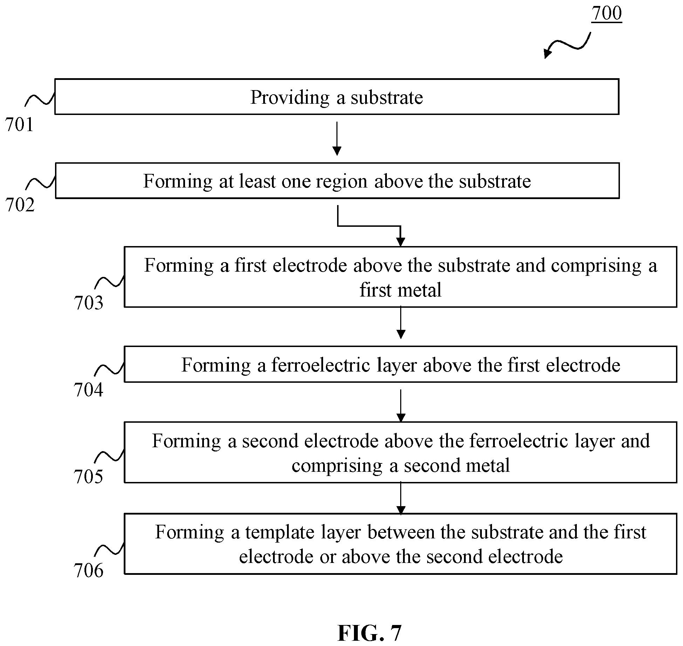

FIG. 7 shows schematically a method 700 for fabricating a ferroelectric device 100, according to the embodiments shown in FIG. 1, FIG. 3, FIG. 4, FIG. 5 or FIG. 6.

The method 700 comprises a step 701 of providing a substrate 110.

Then, the method 700 comprises a step 702 of forming at least one region 120 above a top side of the substrate 110.

The step 702 comprises a step 703 of forming a first electrode 122 above the substrate 110 and comprising a first metal.

Next, the step 702 comprises a step 704 of forming a ferroelectric layer 124 above the first electrode 122.

The step 702 further comprises a step 705 of forming a second electrode 128 above the ferroelectric layer 124 and comprising a second metal.

Further, the step 702 comprises a step 706 of forming a template layer 126 between the substrate 110 and the first electrode 122 and being directly in contact with the first electrode 122. Alternatively, the step 706 comprises forming the template layer 126 above the second electrode 128 and being directly in contact with the second electrode 128.

The template layer 126 has a preferred lattice orientation. When the template layer 126 is directly in contact with the first electrode 122, the first electrode has the preferred lattice orientation of the template layer 126. Alternatively, the second electrode 128 has the preferred lattice orientation of the template layer 126 if it is directly in contact with the template layer 126.

The method 700 may comprises further steps according to the implementation forms of the ferroelectric device 100 according to the embodiments disclosed above in FIG. 1, FIG. 3, FIG. 4, FIG. 5 and FIG. 6.

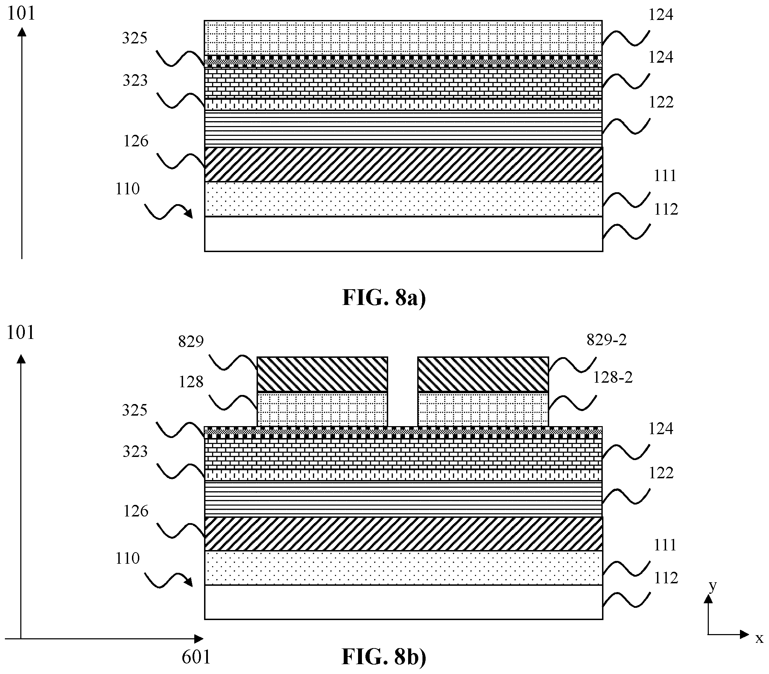

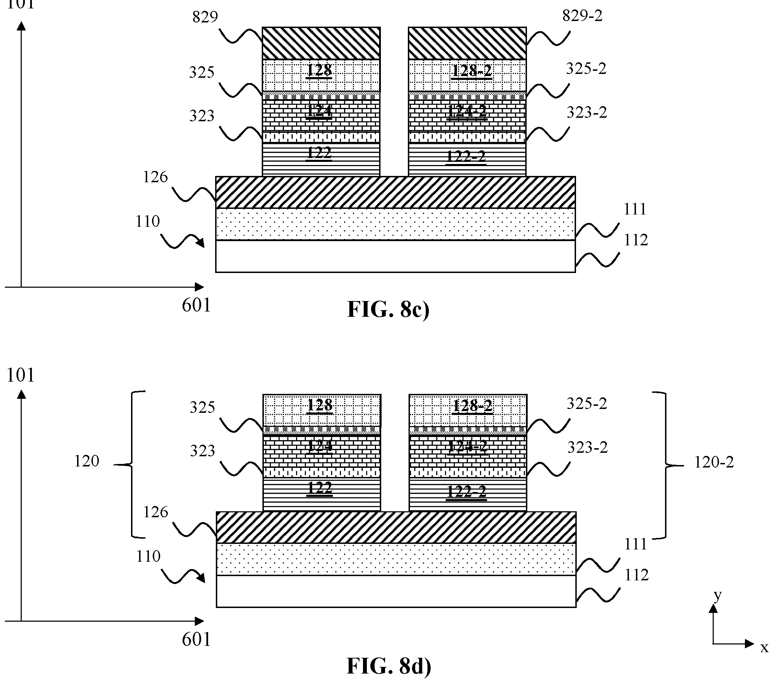

Just as an example and not as a limitation, FIG. 8a) to FIG. 8d) depict an exemplary method for fabricating the ferroelectric device 100 according to FIG. 6.

The method may comprise a step of wafer preparation. That is, a Si wafer is formed with a thickness between 10 nm and 500 nm of the SiO₂ insulation layer 112 grown on Si 111 as the substrate 110, or a Si wafer 111 with SiN 112 grown on it as the substrate 110.

Then, the method comprises a step of AIN layer deposition. In this step an AlN layer 124 or a Al₁₋ₓScₓN layer 124 may be evaporated on the surface of the Si wafer 111 with SiO₂ 112 on top, with a thickness between 5 nm and 1 µ, the AlN layer 124 having the preferred lattice orientation. A usual deposition method of AlN 124 can be, for example, physical vapor deposition (PVD). Other deposition methods, such as atomic layer deposition (ALD), can also be used as long as the preferred lattice orientation is achieved.

Then, the method may comprise a step of first electrode 122 deposition. The first electrode 122 may comprise the first metal, and the first metal may comprise Mo and/or Wand/or TiN and/or other metals. The deposition method may be PVD or ALD, and the thickness of the first electrode 122 may be between 10 nm and 50 nm.

Next, the method may comprise a step of seed layer 323 deposition. This step is optional and may not be required in some structures. The seed layer 323 may comprise an oxide layer, comprising for example TiOx, or NbOx or MoOx, or the like, with a thickness between 0.5 nm and 3 nm. After the seed layer 323 is deposited, it can be annealed at 400~600 °C to make the seed layer 323 denser.

Further, the method may comprise a step of ferroelectric layer 124 deposition. An HZO layer 124 may be deposited by ALD. A thickness of the HZO layer 124 may be between 3 nm and 20 nm. The ferroelectric layer 124 may alternatively comprise HZO having a certain proportion of doping elements, comprising for example La, Si, or W in order to optimize the composition of the ferroelectric phase.

Then, the method may comprise a step of capping layer 325 deposition. This step is optional. The capping layer 325 may comprise a metal oxide with a thickness between 0.5 nm and 3 nm. The capping layer 325 may comprise TiOx, or NbOx, or MoOx or other oxide materials.

The method may comprise a step of second electrode 128 deposition. The second electrode 128 may be deposited using PVD or ALD. The second electrode 128 may comprise a second metal, the second metal comprising Mo and/or W and/or TiN, and its thickness may be between 5~50 nm. After deposition of the second electrode 128, the structure shown in FIG. 8a) can be obtained.

Therefrom, the method may comprise a step of second electrode 128 patterning. A photoresist material layer 829 may be deposited on top of the second electrode 128 layer. Then, wet etching or reactive ion etching can be used to remove the second electrode 128 and the photoresist material 829, to obtain the structure shown in FIG. 8b). That is, the photoresist 829 and the second electrode 128 are etched at two extreme sides of the stack formed as described above, and at a central portion of the stack, exposing the capping layer 325. Thereby, the second electrode 128, 128-2 with a respective resist 829, 829-2 on top for each of the two regions 120, 120-2 may be formed.

Next, the method may comprise a step of stack etching. Wet or reactive ion etching may be further used to remove the capping layer 325, the HZO layer 124, the seed layer 323 and the first electrode 122 layer in regions not covered by the photoresist 829, 829-2. Thereby, a structure shown in FIG. 8c) may be obtained.

The method may further comprise a step of photoresist removal and annealing treatment. The photoresist 829, 829-2 may be removed by solvent or oxygen plasma. Then, the stack may be annealed at 400~650 °C to crystallize the HZO layer 124 and a ferroelectric phase is formed during cooling process. Said ferroelectric phase, thus, may be obtained with the preferred lattice orientation. Then, the two exemplary regions 120, 120 -2 arranged next to each other above the substrate 110 may be formed, as depicted in FIG. 8d).

In the example shown in FIG. 8d), the transition layer 126 may be common to both regions 120, 120-2. This is not limiting in this disclosure. That is, each of the more than one region 120, 120-2 may comprise a transition layer 126 and 126 -2 respectively, and obtained by further etching the crystalized HZO layer in the central portion, i.e., in the central portion of the stack, i.e., a portion between the two regions 120, 120-2.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A ferroelectric device (100) comprising:
a substrate (110); and
at least one region (120) arranged above a top side of the substrate (110), the at least one region (120) comprising:
- a first electrode (122) arranged above the substrate (110) and comprising a first metal;
- a ferroelectric layer (124) arranged above the first electrode (122);
- a second electrode (128) arranged above the ferroelectric layer (124) and comprising a second metal; and
- a template layer (126) having a preferred lattice orientation;
wherein the template layer (126) is arranged between the substrate (110) and the first electrode (122) and is directly in contact with the first electrode (122), or wherein the template layer (126) is arranged above the second electrode (128) and is directly in contact with the second electrode (128); and
wherein the first electrode (122) has the preferred lattice orientation of the template layer (126) if it is directly in contact with the template layer (126); or wherein the second electrode (128) has the preferred lattice orientation of the template layer (126) if it is directly in contact with the template layer (126).

2. The ferroelectric device (100) according to claim 1, wherein the template layer (126) comprises a first polycrystalline material, the first polycrystalline material comprising a plurality of crystal grains of the first material, wherein each of the plurality of the crystal grains of the first material has a same lattice orientation.

3. The ferroelectric device (100) according to claim 1 or 2, wherein the polycrystalline material comprises AlN and/or AlScₓN.

4. The ferroelectric device (100) according to claim 3, wherein a thickness of the template layer (126) is between 5 nanometer, nm, and 1 micrometer, µm.

5. The ferroelectric device (100) according to one of the claims 1 to 4, wherein the ferroelectric layer (124) comprises a ferroelectric polycrystalline material having the lattice orientation of the template layer (126).

6. The ferroelectric device (100) according to claim 5, wherein the ferroelectric polycrystalline material comprises Hafnium zirconium oxide, HZO.

7. The ferroelectric device (100) according to one of the claims 5 or 6, wherein a thickness of the ferroelectric layer (124) is between 3 nm and 20 nm.

8. The ferroelectric device (100) according to one of the claims 1 to 7, wherein the first electrode (122) having the preferred lattice orientation of the template layer (126) comprises a plurality of crystal grains of the first metal, wherein each of the plurality of the crystal grains of the first metal has the same lattice orientation than the first polycrystalline material.

9. The ferroelectric device (100) according to claim 8 wherein the first metal comprises Mo and/or W and/or TiN.

10. The ferroelectric device (100) according to claim 8 or 9, wherein a thickness of the first electrode (122) is between 10 nm to 50 nm.

11. The ferroelectric device (100) according to one of the claims 4 to 10, wherein the second electrode (128) having the preferred lattice orientation of the template layer (126) comprises a plurality of crystal grains of the second metal, wherein each of the plurality of the crystal grains of the second metal has the same lattice orientation than the first polycrystalline material.

12. The ferroelectric device (100) according to claim 11, wherein the second metal comprises Mo or W or TiN.

13. The ferroelectric device (100) according to claim 11 or 12, wherein a thickness of the second electrode (128) is between 5 nm to 50 nm.

14. The ferroelectric device (100) according to one of the claims 1 to 13, wherein the at least one region (120) further comprises:
a seed layer (323, 523) arranged between the first electrode (122) and the ferroelectric layer (124);
wherein the seed layer (323, 523) comprises an oxide material, and
wherein a thickness of the seed layer (323, 523) is between 0.5 nm and 3 nm.

15. The ferroelectric device (100) according to one of the claims 1 to 14, wherein the at least one region (120) further comprises:
a capping layer (325, 525) arranged between the ferroelectric layer (124) and the second electrode (128);
wherein the capping layer (325, 525) comprises a metal oxide material, and
wherein a thickness of the capping layer (325, 525) is between 0.5 nm and 3 nm.

16. The ferroelectric device (100) according to one of the claims 1 to 15, comprising more than one regions (120, 120-2) arranged next to each other.

17. A method (700) for fabricating a ferroelectric device, the method comprising:
providing (701) a substrate (110); and
forming (802) at least one region (120) above a top side of the substrate (110), comprising:
- forming (703) a first electrode (122) above the substrate (110) and comprising a first metal;
- forming (704) a ferroelectric layer (124) above the first electrode (122);
- forming (705) a second electrode (128) above the ferroelectric layer (124) and comprising a second metal; and
- forming (706) a template layer (126) between the substrate (110) and the first electrode (122) and being directly in contact with the first electrode (122); or forming the template layer (126) above the second electrode (128) and being directly in contact with the second electrode (128);
wherein the template layer (126) has a preferred lattice orientation; and
wherein the first electrode (122) has the preferred lattice orientation of the template layer (126) if it is directly in contact with the template layer (126); or the second electrode (128) has the preferred lattice orientation of the template layer (126) if it is directly in contact with the template layer (126).

## Amended claims

### Amended claims in accordance with Rule 137(2) EPC.

1. A ferroelectric device (100) comprising:
a substrate (110); and
at least one region (120) arranged above a top side of the substrate (110), the at least one region (120) comprising:
- a first electrode (122) arranged above the substrate (110) and comprising a first metal;
- a ferroelectric layer (124) arranged above the first electrode (122);
- a second electrode (128) arranged above the ferroelectric layer (124) and comprising a second metal; and
- a template layer (126) having a preferred lattice orientation;
wherein the template layer (126) is arranged between the substrate (110) and the first electrode (122) and is directly in contact with the first electrode (122); and
wherein the first electrode (122) has the preferred lattice orientation of the template layer (126) if it is directly in contact with the template layer (126);
wherein the ferroelectric layer (124) comprises a ferroelectric polycrystalline material having the lattice orientation of the template layer (126).

2. The ferroelectric device (100) according to claim 1, wherein the template layer (126) comprises a first polycrystalline material, the first polycrystalline material comprising a plurality of crystal grains of the first material, wherein each of the plurality of the crystal grains of the first material has a same lattice orientation.

3. The ferroelectric device (100) according to claim 1 or 2, wherein the polycrystalline material comprises AlN and/or AlScₓN.

4. The ferroelectric device (100) according to claim 3, wherein a thickness of the template layer (126) is between 5 nanometer, nm, and 1 micrometer, µm.

5. The ferroelectric device (100) according to claim 1, wherein the ferroelectric polycrystalline material comprises Hafnium zirconium oxide, HZO.

6. The ferroelectric device (100) according to claim 1 or 5, wherein a thickness of the ferroelectric layer (124) is between 3 nm and 20 nm.

7. The ferroelectric device (100) according to one of the claims 1 to 6, wherein the first electrode (122) having the preferred lattice orientation of the template layer (126) comprises a plurality of crystal grains of the first metal, wherein each of the plurality of the crystal grains of the first metal has the same lattice orientation than the first polycrystalline material.

8. The ferroelectric device (100) according to claim 7 wherein the first metal comprises Mo and/or W and/or TiN.

9. The ferroelectric device (100) according to claim 7 or 8, wherein a thickness of the first electrode (122) is between 10 nm to 50 nm.

10. The ferroelectric device (100) according to one of the claims 1 to 9, wherein the at least one region (120) further comprises:
a seed layer (323, 523) arranged between the first electrode (122) and the ferroelectric layer (124);
wherein the seed layer (323, 523) comprises an oxide material, and
wherein a thickness of the seed layer (323, 523) is between 0.5 nm and 3 nm.

11. The ferroelectric device (100) according to one of the claims 1 to 10, wherein the at least one region (120) further comprises:
a capping layer (325, 525) arranged between the ferroelectric layer (124) and the second electrode (128);
wherein the capping layer (325, 525) comprises a metal oxide material, and
wherein a thickness of the capping layer (325, 525) is between 0.5 nm and 3 nm.

12. The ferroelectric device (100) according to one of the claims 1 to 11, comprising more than one regions (120, 120-2) arranged next to each other.

13. A method (700) for fabricating a ferroelectric device, the method comprising:
providing (701) a substrate (110); and
forming (702) at least one region (120) above a top side of the substrate (110), comprising:
- forming (703) a first electrode (122) above the substrate (110) and comprising a first metal;
- forming (704) a ferroelectric layer (124) above the first electrode (122);
- forming (705) a second electrode (128) above the ferroelectric layer (124) and comprising a second metal; and
- forming (706) a template layer (126) between the substrate (110) and the first electrode (122) and being directly in contact with the first electrode (122); or forming the template layer (126) above the second electrode (128) and being directly in contact with the second electrode (128);
wherein the template layer (126) has a preferred lattice orientation; and
wherein the first electrode (122) has the preferred lattice orientation of the template layer (126) if it is directly in contact with the template layer (126);
wherein the ferroelectric layer (124) comprises a ferroelectric polycrystalline material having the lattice orientation of the template layer (126).
